(19)

Europäisches Patentamt
European Patent Office
Office européen des brevets

(11) **EP 4 425 363 A1**

(12) **EUROPEAN PATENT APPLICATION**
published in accordance with Art. 153(4) EPC

(43) Date of publication:
**04.09.2024 Bulletin 2024/36**

(21) Application number: **21961615.8**

(22) Date of filing: **28.10.2021**

(51) International Patent Classification (IPC):
*G06F 30/10* (2020.01)

(52) Cooperative Patent Classification (CPC):
**G06F 30/10**

(86) International application number:
**PCT/JP2021/039854**

(87) International publication number:
**WO 2023/073875 (04.05.2023 Gazette 2023/18)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Core Concept Technologies Inc.**
**Tokyo 171-0022 (JP)**
• **Ibaraki University**
**Ibaraki 310-8512 (JP)**

(72) Inventors:
• **TAGUCHI, Tadaaki**
**Tokyo 171-0022 (JP)**
• **INUI, Masatomo**
**Hitachi-shi Ibaraki 316-8511 (JP)**
• **KOMORI, Soichiro**
**Tokyo 171-0022 (JP)**
• **TANAKA, Akio**
**Kawaguchi-shi Saitama 332-0011 (JP)**
• **Shimomura, Katsunori**
**Tokyo 171-0022 (JP)**

(74) Representative: **Müller-Boré & Partner**
**Patentanwälte PartG mbB**
**Friedenheimer Brücke 21**
**80639 München (DE)**

(54) **THREE-DIMENSIONAL CAD SYSTEM**

(57)     Provided is a three-dimensional CAD system that is capable of displaying, at high speed, a shape including a curved surface in the form of a CSG representation. The present invention is provided with: a primitive generation unit (11) that generates a primitive by joining the edges of differential polyhedrons to configure curved surfaces and joining the curved surfaces via curved surface boundaries to configure a closed curved surface, the primitive being a set of points belonging to the inside of the closed curved surface, by using a differential polyhedron model, which is a set of differential polyhedrons including the coordinate values of the vertices of triangles, the normal vectors of the vertices of triangles, and curved line elements constituted of initial points and terminal points, as well as tangential vectors of the initial points and the terminal points, the initial points and the terminal points being constituted of the vertices of triangles; a storage unit (2) that stores CSG data representing a solid model in the form of a CSG representation by using a tree structure of set operations for the primitive; and a display processing unit (3) that obtains the intersection between the solid model and a ray from the intersection between the closed curved surface of the primitive and the ray through set operations based on the CSG data, and that calculates the position of reflection and the direction of reflection of the ray in the solid model.

FIG.1

## Description

TECHNICAL FIELD

The present technology relates to a three-dimensional CAD system using a solid model.

BACKGROUND ART

The basic idea of Digital Transformation (DX) is to virtualize existing works and replacing more of tasks with more reliable and faster algorithmic processing to prominently improve productivity. In order to virtually express "things" handled in the manufacturing industry, it is necessary to make a three-dimensional model to represent the "things" in a virtual world, which is not easy as compared with numerical values and texts.

Conventionally, a three-dimensional CAD (3D Computer Aided Design) system is used to make a three-dimensional model of "things," but trouble often occurs in data conversion between three-dimensional CAD systems. This hinders smooth cooperation between systems, which is the reason why DX is not widely used in the manufacturing industry.

As standards and mechanisms for three-dimensional model conversion between three-dimensional CAD systems, e.g., the ANSI (American National Standard Institute) standard IGES (Initial Graphics Exchange Specification) and the ISO (International Organization for Standardization) standard STEP (Standard for the Exchange of Product model data) have been established; however, data conversion might not be successful with these standards alone. The main reason for this is that the mechanism for handling calculation errors, which is called modeling accuracy, is different between three-dimensional CAD systems. The modeling accuracy is required in representation of a three-dimensional model.

Shapes represented by three-dimensional models include wireframe models, surface models, and solid models, among others, and most three-dimensional CAD systems are solid models. There have been considered two methods of representing solid models, B-Rep (Boundary Representation) and CSG (Constructive Solid Geometry).

B-Rep is a representation method in which the surface of a three-dimensional model is covered with a plurality of curved surfaces, which are bonded together at a boundary to form a closed surface, and the inside of which is regarded as a target three-dimensional model. On the other hand, CSG is a method of forming a three-dimensional model by a set operation of a basic shape called a primitive (see, e.g., Non-Patent Document 1).

B-Rep representation is more convenient for handling free-form surfaces and using as interfaces for 3D CAM (3D Computer Aided Manufacturing), which applies three-dimensional models. Therefore, most current 3D CAD systems use B-Rep, and CSG is used only as an assisting purpose. B-Rep is also used in STEP, which is a standard for converting three-dimensional data.

However, B-Rep requires curved surfaces to be introduced in three-dimensional models, which introduces modeling errors. In the present three-dimensional CAD system, parametric surfaces such as B-spline curved surfaces are mainly used. The parametric surface is a curved surface formed by projecting a rectangle in a (u, v) space into an xyz space by a two-variable function F (u, v). Therefore, a quadrangle is the basic form.

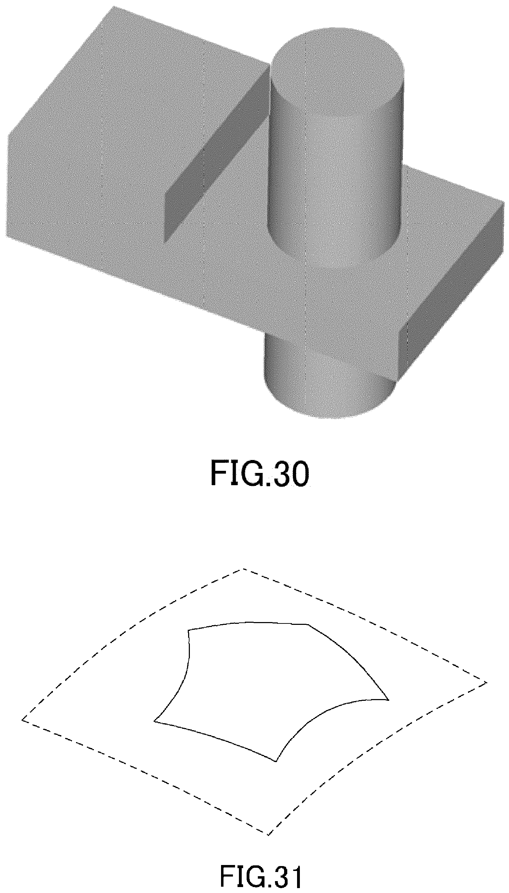

FIG. 31 is a view illustrating an example of a curved surface trimmed by a boundary line in B-Rep. As shown in FIG. 31, the B-Rep trims a curved surface by a boundary line and uses a trimmed curved surface. The curved surface boundary line is represented by a parametric curve expressed by parameters, so that the curved surface boundary line does not exactly lie on the curved surface; this representation only indicates that the curved surface boundary line lies on the curved surface if the gap between the curved surface boundary line and the curved surface is less than the modeling accuracy.

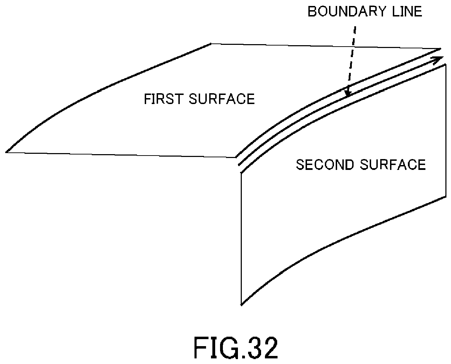

FIG. 32 is a view illustrating an example of a curved surface boundary line connecting curved surfaces in B-Rep. As shown in FIG. 32, in B-Rep, the curved surfaces are connected to each other by the information of the first surface and the second surface with respect to the boundary line, and the inside of the curved surface is recognized as a solid model as a whole. Therefore, there is inevitably a gap between curved surfaces. Since the modeling accuracy differs depending on the three-dimensional CAD system, this is the main cause of the failure in the conversion between the three-dimensional models.

On the other hand, CSG representation is currently used to assist B-Rep representation. The representation of the solid model by CSG has an advantage that it is not necessary to consider the modeling error, which is the main cause of the data conversion trouble. The reasons why the three-dimensional CAD system of CSG representation did not become the mainstream includes the slow rendering speed and the difficulty in representing the shape including curved surfaces due to insufficient number of types of primitives which are the basic elements of the three-dimensional model.

CITATION LIST

NON-PATENT LITERATURE

NPL 1: Introduction to Solid Modeling, Martti Mantyla, 1988

SUMMARY OF INVENTION

TECHNICAL PROBLEM

The present technology has been proposed in view of such conventional circumstances and provides a three-dimensional CAD system capable of quickly rendering a shape including a curved surface in CSG representation.

SOLUTION TO PROBLEM

A three-dimensional CAD system according to the present technology includes: a primitive generation unit that uses a differential polyhedron model which is a set of differential polyhedrons including coordinate values of triangle vertices, normal vectors of the triangle vertices, and curved line elements including start/end points consisting of the triangle vertices and tangent vectors at the start/end points to form a curved surface by connecting sides of the differential polyhedron and form a closed surface by connecting curved surfaces with a curved surface boundary line, thereby generating a primitive which is a set of points belonging to the inside of the closed surface; a storage unit that stores CSG data which represents a solid model in CSG representation by a tree structure of set operations of the primitives; and a representation processing unit that determines an intersection point between the solid model and a straight line from the intersection point between the closed surface of the primitive and the straight line by a set operation based on the CSG data, thereby calculating a reflection position and a reflection direction of a light ray in the solid model.

A three-dimensional CAD method according to the present technology includes: a primitive generation step of using a differential polyhedron model which is a set of differential polyhedrons including coordinate values of triangle vertices, normal vectors of the triangle vertices, and curved line elements including start/end points consisting of the triangle vertices and tangent vectors at the start/end points to form a curved surface by connecting sides of the differential polyhedron and form a closed surface by connecting curved surfaces with a curved surface boundary line, thereby generating a primitive which is a set of points belonging to the inside of the closed surface; a storage step of storing CSG data which represents a solid model in CSG representation by a tree structure of set operations of the primitives; and a representation processing step of determining an intersection point between the solid model and a straight line from the intersection point between the closed surface of the primitive and the straight line by a set operation based on the CSG data, thereby calculating a reflection position and a reflection direction of a light ray in the solid model.

A three-dimensional CAD program according to the present technology causes a computer to execute: a primitive generation step of using a differential polyhedron model which is a set of differential polyhedrons including coordinate values of triangle vertices, normal vectors of the triangle vertices, and curved line elements including start/end points consisting of the triangle vertices and tangent vectors at the start/end points to form a curved surface by connecting sides of the differential polyhedron and form a closed surface by connecting curved surfaces with a curved surface boundary line, thereby generating a primitive which is a set of points belonging to the inside of the closed surface; a storage step of storing CSG data which represents a solid model in CSG representation by a tree structure of set operations of the primitives; and a representation processing step of determining an intersection point between the solid model and a straight line from the intersection point between the closed surface of the primitive and the straight line by a set operation based on the CSG data, thereby calculating a reflection position and a reflection direction of a light ray in the solid model.

ADVANTAGEOUS EFFECTS OF INVENTION

According to the present technology, it is possible to represent a shape including curved surfaces in CSG representation without considering a modeling error and to quickly render a solid model.

BRIEF DESCRIPTION OF DRAWINGS

FIG. 1 is a block diagram illustrating a configuration example of a three-dimensional CAD system according to the present embodiment.
FIG. 2 is a block diagram illustrating an example of a configuration of a computer device for implementing a three-dimensional CAD system according to the present embodiment.

FIG. 3 is a view for explaining a subdivision process of a differential polyhedron, in which FIG. 3A shows a triangular model, FIG. 3B shows a boundary line defined by a spatial geodesic, FIG. 3C shows a first differential polyhedron, and FIG. 3D shows a second differential polyhedron.

FIG. 4 is a view for explaining a subdivision process of a differential polyhedron including a curved line element, in which FIG. 4A shows a triangular model including a curved line element, FIG. 4B shows a boundary line defined by the curved line element, and FIG. 4C shows a first differential polyhedron.

FIG. 5A is a view for explaining a differential polyhedron, and FIG. 5B is a view for explaining curved line element information.

FIG. 6 is a view for explaining the data structure of the primitive and the data structure of the primitive in CSG representation.

FIG. 7 is a view illustrating an example of a curved surface and a curved surface boundary line.

FIG. 8 is a view illustrating an example of a curved surface having no boundary line.

FIG. 9 is a view illustrating a cube as an example of a closed surface.

FIG. 10 is a view illustrating a cylinder as an example of a closed surface.

FIG. 11 is a view illustrating a free-form surface as an example of a closed surface.

FIG. 12 is a view illustrating an example of a tree structure having a union set and intersection set of primitives.

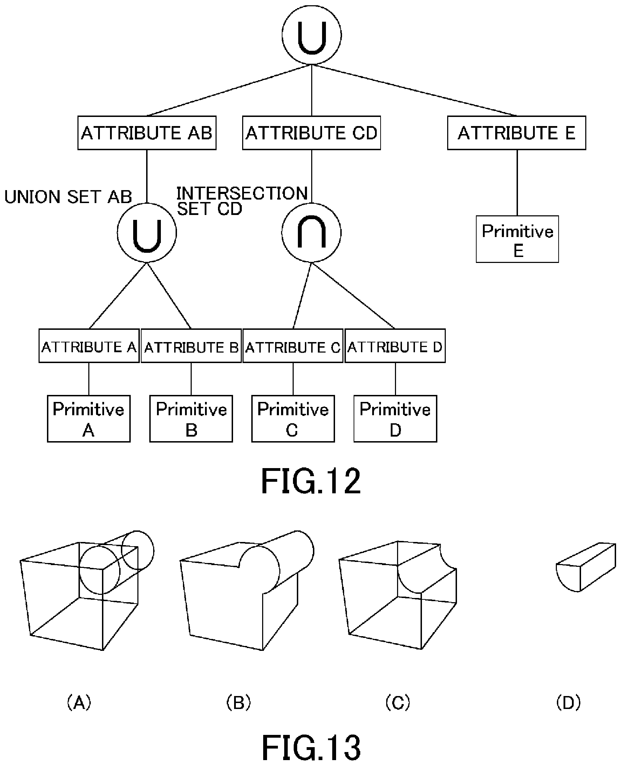

FIG. 13 is a view schematically illustrating an example of a set operation result of a primitive, in which FIG. 13A is a view schematically illustrating an example of a rectangular primitive A and a cylinder primitive B, FIG. 13B is a view schematically illustrating an example of the union A U B of the rectangular primitive A and the cylinder primitive B, FIG. 13C is a view schematically illustrating an example of the intersection A∩B~ of the rectangular primitive A and the cylinder primitive B, and FIG. 13D is a view schematically illustrating an example of the intersection A ∩ B of the rectangular primitive A and the cylinder primitive B.

FIG. 14 is a view illustrating an example of a tree structure in which the arithmetic symbol is omitted from the tree structure shown in FIG. 12.

FIG. 15 is a view illustrating an example of a tree structure of a feature.

FIG. 16 is a view illustrating an example of a tree structure of a part.

FIG. 17 is a view for explaining shading, in which FIG. 17A is a view for explaining flat shading, and FIG. 17B is a view for explaining Phong shading.

FIG. 18 is a flowchart for explaining a real-time ray tracing process.

FIG. 19 is a view for explaining a calculation method of a temporary bit string, in which FIG. 19A shows a temporary bit operation of a union set, and FIG. 19B shows a temporary bit operation of an intersection set.

FIG. 20 is a view schematically illustrating a situation where light rays 1 to 3 pass through a solid model in CSG representation.

FIG. 21 is a view illustrating an example of a tree structure of the solid model in CSG representation shown in FIG. 20.

FIG. 22 is a view schematically illustrating a situation where a light ray 1 passes through a solid model in CSG representation.

FIG. 23 is a view for explaining intersection point information where the light ray 1 passes through a feature.

FIG. 24 is a view schematically illustrating a situation where a light ray 2 passes through a solid model in CSG representation.

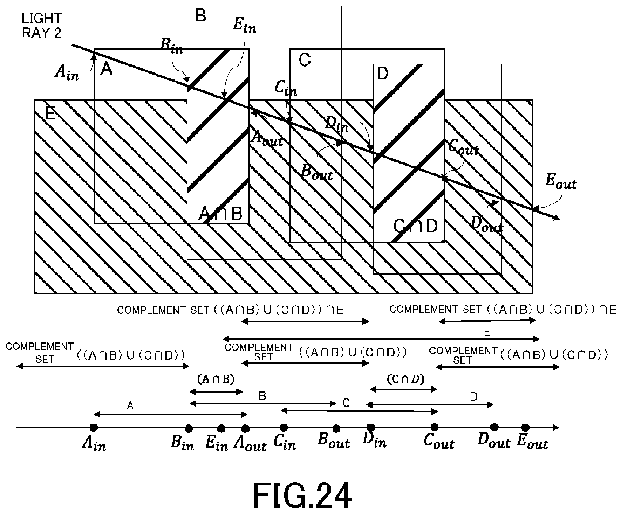

FIG. 24 is a view for explaining intersection point information where the light ray 2 passes through a feature.

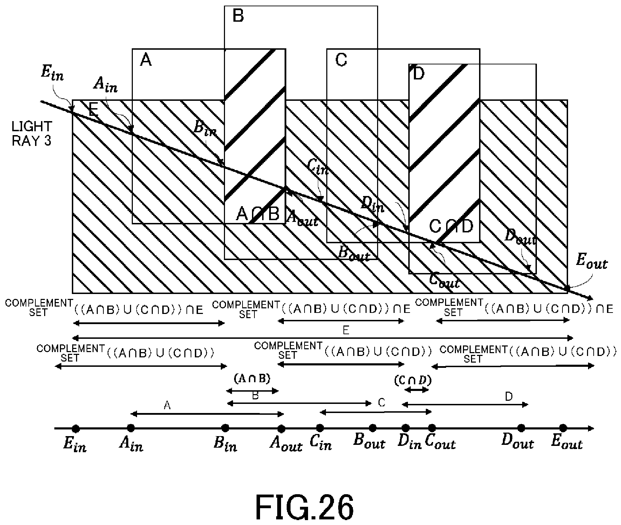

FIG. 26 is a view schematically illustrating a situation where a light ray 3 passes through a solid model in CSG representation.

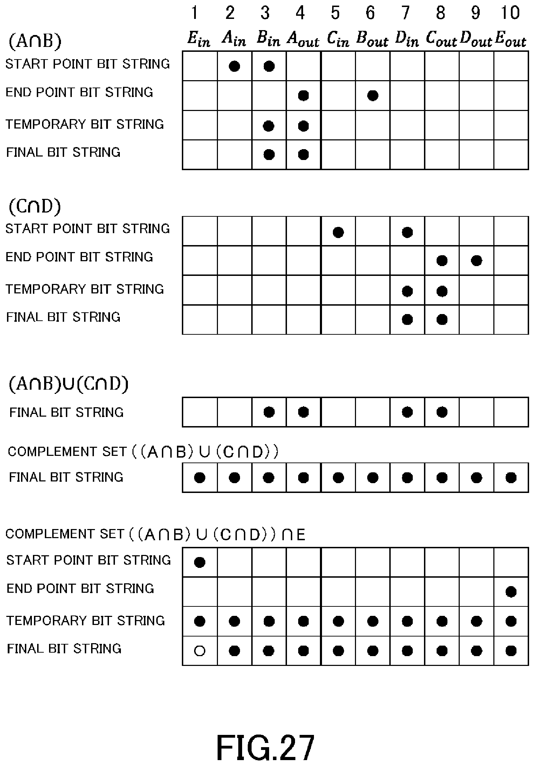

FIG. 27 is a view for explaining intersection point information where the light ray 3 passes through the feature.

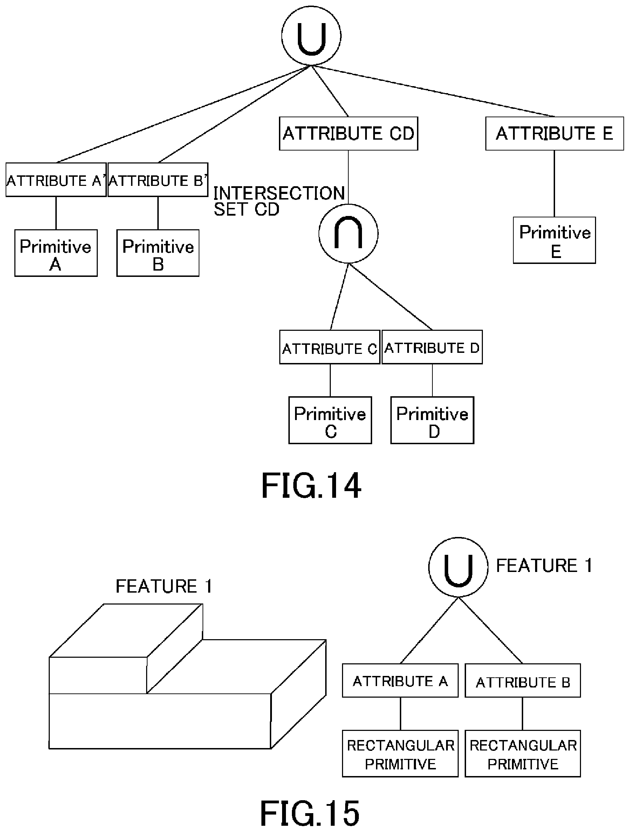

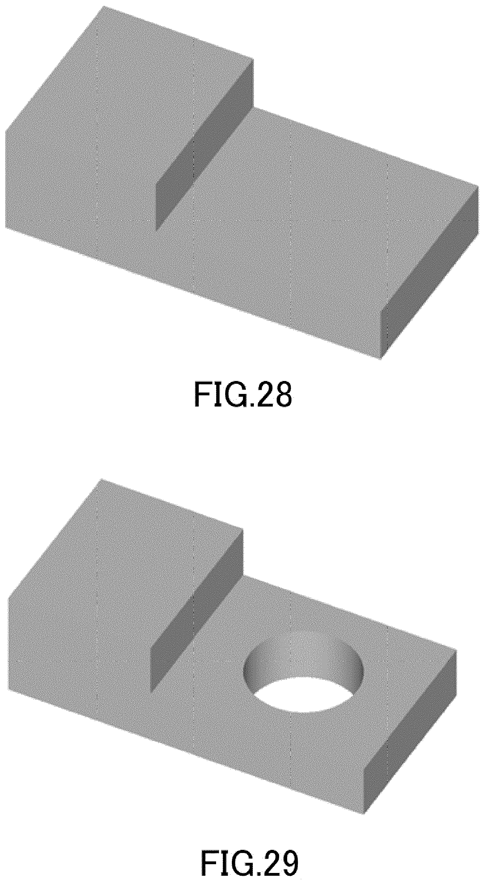

FIG. 28 is a view illustrating a rendering example of a feature 1 shown in FIG. 15.

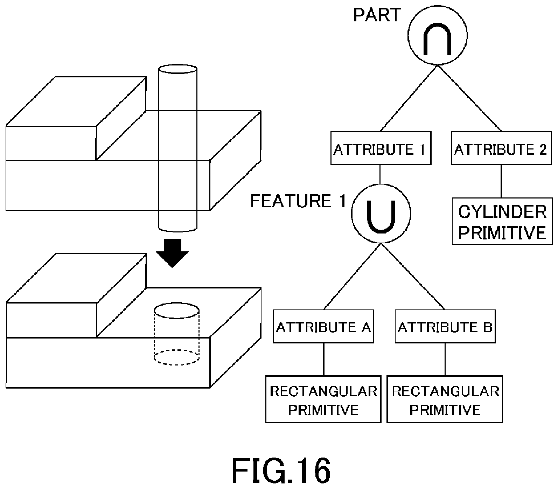

FIG. 29 is a view illustrating a rendering example of the part shown in FIG. 16.

FIG. 30 is a rendering example of the part obtained by performing a union set operation of the feature 1 and the cylinder.

FIG. 31 is a view illustrating an example of the curved surface trimmed by a curved surface boundary line in B-Rep.

FIG. 32 is a view illustrating an example of a boundary line connecting curved surfaces in B-Rep.

## DESCRIPTION OF EMBODIMENTS

Embodiments of the present technology will be described in detail in the following order with reference to the drawings.

1. THREE-DIMENSIONAL CAD SYSTEM
2. CURVED SURFACE WITH DIFFERENTIAL POLYHEDRON

3. PRIMITIVE SET OPERATIONS
4. THREE-DIMENSIONAL MODEL REPRESENTATION

1. THREE-DIMENSIONAL CAD SYSTEM

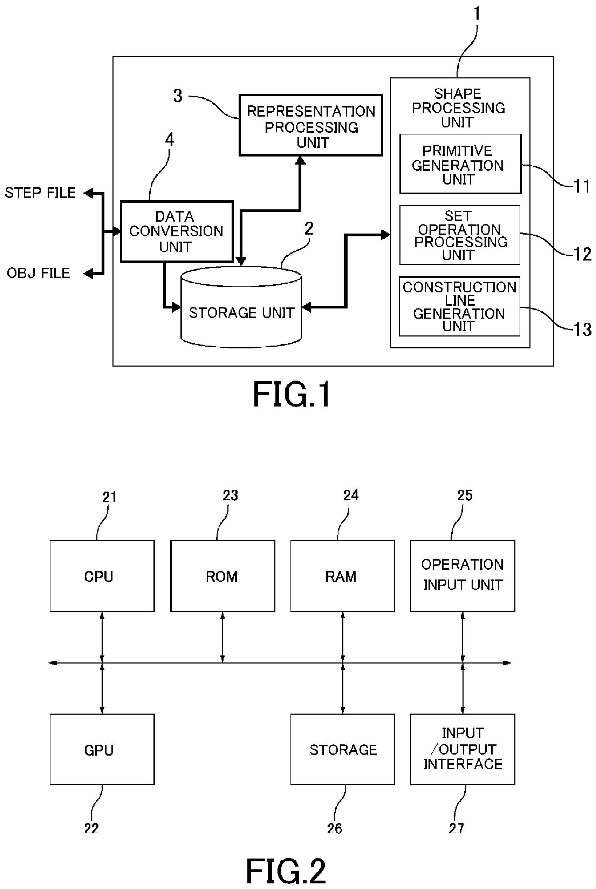

FIG. 1 is a block diagram illustrating a configuration example of a three-dimensional CAD system according to the present embodiment. As shown in FIG. 1, the three-dimensional CAD system includes: a shape processing unit 1 that performs shape processing of primitives; a storage unit 2 for storing CSG (Constructive Solid Geometry) data; a representation processing unit 3 that represents a solid model in CSG representation; and a data conversion unit 4 that converts data of another format into data of CSG representation and converts data of CSG representation into data of another format. The shape processing unit 1 includes a primitive generation unit 11, a set operation processing unit 12, a construction line generation unit 13.

The primitive generation unit 11 uses a differential polyhedron model which is a set of differential polyhedrons including coordinate values of triangle vertices, normal vectors of triangle vertices, curved line elements including start/end points consisting of the triangle vertices and tangent vectors at the start/end points. Then, the primitive generation unit 11 forms a curved surface by connecting the sides of the differential polyhedron and forms a closed surface by connecting curved surfaces with a curved surface boundary line, thereby generating a primitive which is a set of points belonging to the inside of the closed surface. Thus, the shape including the curved surface can be easily expressed. Here, the closed surface means a surface that separates a three-dimensional space into two regions.

The primitive generation unit 11 generates a differential polyhedron by adding curved line elements including start/end points consisting of triangle vertices and tangent vectors at the start/end points on the basis of the coordinate values of the triangle vertices and the normal vector of the triangle vertices. Thus, e.g., a differential polyhedron can be generated by using a triangle having normal vector information at vertices.

The primitive generation unit 11 generates a spatial geodesic by using the coordinate values of the triangle vertices shared by the adjacent first differential polyhedron and the second differential polyhedron and the normal vector of the triangle vertices to construct a connection relation by sharing the spatial geodesic, thereby forming a curved surface. In other words, the primitive generation unit 11 constructs a connection relation by sharing a spatial geodesic line between the first differential polyhedron and the second differential polyhedron adjacent to each other, and forms a curved surface by using this connection relation.

Further, the primitive generation unit 11 constructs a connection relation between curved surfaces by using a curved line element shared between curved surfaces, and forms a closed surface connecting curved surfaces. When a connection relation between curved surfaces is constructed by using a curved line element shared between curved surfaces and the curved surfaces are connected, the connection relation of the curved line elements between curved surfaces becomes a boundary line between the curved surfaces, and this becomes a curved surface boundary line. Thus, the curved surfaces can be connected by a curved surface boundary line constituted by the connection of curved line elements without considering the modeling error.

The curved line element is preferably expressed by a cubic polynomial curve represented by the following Formula 1.

[Formula 1]

$$\vec{C}(t) = \vec{A}t^3 + \vec{B}t^2 + \vec{C}t + \vec{D} \quad ; 0 \le t \le \text{curved line element length} \qquad (1)$$

Here, $\vec{A}, \vec{B}, \vec{C}$ and $\vec{D}$ are coefficients.

Here, the curved line element includes start/end points consisting of triangle vertices, and tangent vectors at the start/end points, and the length of the curved line element can be expressed by the following Formula 2.

[Formula 2]

$$\int_0^{\text{curved line element length}} \left| \frac{d\vec{C}(t)}{dt} \right| dt \qquad (2)$$

Since the length of the curve appears as the upper limit value of the integration in Formula (2), the coefficients $\vec{A}, \vec{B}, \vec{C},$ and $\vec{D}$ are determined by repeating the calculation so that the length of the curve = Formula 2.

The set operation processing unit 12 performs set operation between primitives and this set operation is performed only by symbol operation. Performing the set operation only by symbol operation will simplify the data structure and stabilize the set operation. In the tree structure of the set operation of primitives, when a lower operation symbol is the same as the upper operation symbol in the hierarchy, the set operation processing unit 12 omits the set operation symbol.

This can reduce operation amount.

A construction line generation unit 13 generates an intersection line of the two primitives as a construction line. Thus, the primitive generation unit 11 can generate a new primitive based on the construction line.

The storage unit 2 stores CSG data which represents a solid model in CSG representation by a tree structure of set operations of primitives. The storage unit 2 is a storage such as a RAM (Random Access Memory) or a hard disk for storing CSG data to be shape-processed by the shape processing unit 1. As will be described later, the CSG data has a tree structure in which primitives can be constructed by a set model of triangles and set operations between primitives can be performed. With this CSG data, a solid model can be represented by using a tree structure by set operations between primitives.

The representation processing unit 3 determines an intersection point of a solid model and a light ray from an intersection of a closed surface of a primitive and the light ray by a set operation based on the CSG data, and calculates the reflection position and the reflection direction of the light ray in the solid model.

In the tree structure of the set operation of primitives, when a lower set operation symbol is the same as the upper set operation symbol in the hierarchy, the representation processing unit 3 omits the set operation symbol and determines the intersection point between the solid model and the light ray. This can reduce the operation amount to quickly render the solid model in CSG representation.

The representation processing unit 3 is, e.g., a GPU (Graphics Processing Unit), has a ray tracing API (Application Programming Interface) based on CUDA (Compute Unified Device Architecture), and uses real-time ray tracing to determine an intersection point between a solid model and a light ray. Thus, a hardware device can quickly calculate an intersection point between the light ray and the closed surface of the primitive as well as normal vectors of the closed surface at the intersection point, and can render them in real time.

The data conversion unit 4 converts a file such as STEP (Standard for the Exchange of Product model data) or IGES (Initial Graphics Exchange Specification) into CSG representation data, and converts the CSG representation data into a file such as STEP or IGES.

This three-dimensional CAD system uses a differential polyhedron as a basic element to form a closed surface by connecting sides of the differential polyhedron, and form a closed surface by connecting curved surfaces with a curved surface boundary line, so that a shape including a curved surface can be represented by CSG without considering a modeling error, and a solid model can be quickly rendered.

FIG. 2 is a block diagram illustrating an example of a configuration of a computer device for implementing a three-dimensional CAD system according to the present embodiment. As shown in FIG. 2, the computer device includes: a CPU (Central Processing Unit) 21 for executing a program; a GPU (Graphics Processing Unit) 22 for executing operational processing; a ROM (Read Only Memory) 23 for storing a program executed by the CPU 21; a RAM (Random Access Memory) 24 for loading programs and data; an operation input unit 25 for receiving various input operations by a user; a storage 26 for storing programs and data in a non-volatile manner; and an input/output interface 27 for inputting and outputting data.

For example, the CPU 21 can perform the processing of the primitive generation unit 11, the set operation processing unit 12, and the construction line generation unit 13. Further, the CPU 21 reads a three-dimensional CAD program stored in, e.g., the storage 26, load the program into the RAM 24, and executes the program to control the operation of each block.

The GPU 22 has a video memory (VRAM) and can perform drawing processing and calculation processing in response to a request from the CPU 21. The GPU 22 has, e.g., a ray tracing API (Application Programming Interface) described on the basis of CUDA (Compute Unified Device Architecture).

The ROM 23 is, e.g., a read only nonvolatile memory, and stores information such as constants necessary for the operation of each block of the computer device. The RAM 24 is a volatile memory which is used not only as a loading area for an operation program but also as a storage area for temporarily storing intermediate data or the like output in the operation of each block of the computer device.

The operation input unit 25 is a user interface used for input operations on the computer device 1. The operation input unit 25 outputs an instruction for executing or stopping information processing to the CPU 21 in response to input operations conducted by a user.

The storage 26 records the information processing program and the like to be loaded into the RAM 24. The storage 26 may be a hard disk drive (HDD), a solid state drive (SSD), and an optical drive, among others. The input/output interface 27 can output an image generated by the GPU 22 to a display device.

In such a hardware configuration, the three-dimensional CAD system described above can be implemented by cooperation of software executed by the CPU 21, the GPU 22, the ROM 23, the RAM 24, and the CPU 21, among others. The software program may be stored in and distributed as a recording medium such as an optical disk or a semiconductor memory, or may be downloaded via the Internet.

2. CURVED SURFACE WITH DIFFERENTIAL POLYHEDRON

DIFFERENTIAL POLYHEDRON MODEL

A differential polyhedron model is a set of differential polyhedrons which are basic elements, and also a set of points generated by repeating subdivision of the differential polyhedron. For the subdivision of the differential polyhedron, the center point of the boundary line connecting the two points of the triangle can be used. The boundary line may be a spatial geodesic or a curved line element, and in either case this is called a differential polyhedron. Here, the vertex of the differential polyhedron is defined as a point, and the side is defined as an edge.

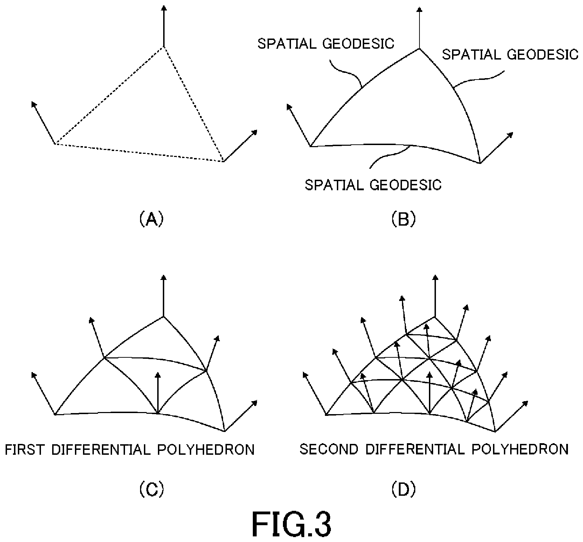

FIG. 3 is a view for explaining a subdivision process of a differential polyhedron, in which FIG. 3A shows a triangular model, FIG. 3B shows a boundary line by a spatial geodesic, FIG. 3C shows a first differential polyhedron, and FIG. 3D shows a second differential polyhedron. In the differential polyhedron model, edges coinciding with each other are considered to be the same line segment and defined as a ridge, and both ends of the ridge are defined as vertices. The differential polyhedron is subdivided by generating a spatial geodesic by using normal vectors of vertices at both ends of ridges of the differential polyhedron model, and generating two ridges by adding vertices and normal vectors to the center point of the spatial geodesic. Since the processing by the computer needs to be finished in a finite number of times, it is approximated by a small triangle composed of three points after finite-time subdivisions. A polyhedron with n-time subdivisions is called an n-th differential polyhedron.

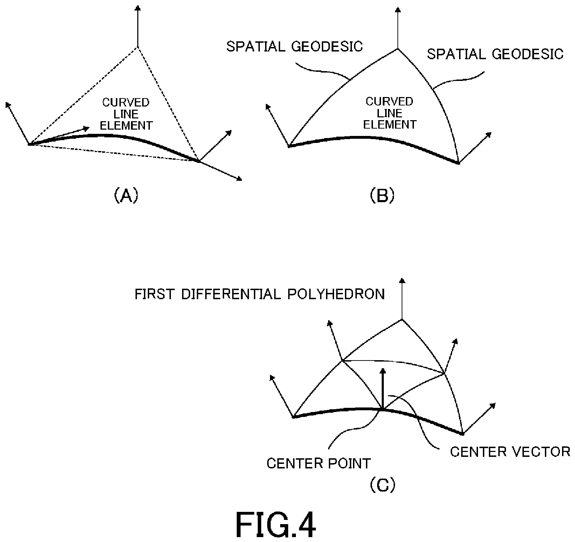

FIG. 4 is a view for explaining a subdivision process of a differential polyhedron including a curved line element, in which FIG. 4A shows a triangular model including a curved line element, FIG. 4B shows a boundary line by the curved line element, and FIG. 4C shows a first differential polyhedron. A curved line element consists of two vertices of a triangle and tangent vectors at the vertices. As shown in FIG. 4C, when the boundary line is a curved line element, subdivision can use the center point of the curved line element to define a center vector by the average of the normal vectors at both ends of the curved line element.

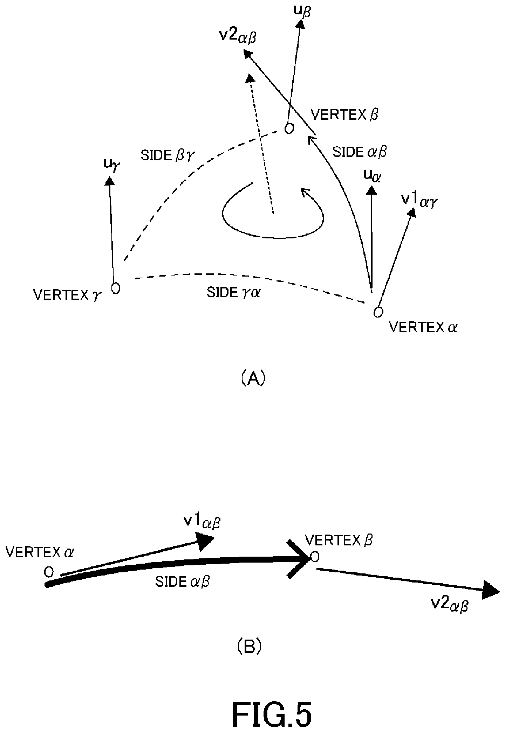

FIG. 5A is a view for explaining a differential polyhedron, and FIG. 5B is a view for explaining curved line element information. A differential polyhedron model is a set of differential polyhedrons which are basic elements, and includes point information of vertices ($\alpha$, $\beta$, $\gamma$) of triangles, curved line element information of sides ($\alpha\beta$, $\beta\gamma$, $\gamma\alpha$) of triangles, and triangle information including point IDs of the point information and curved line element IDs of the curved line element information. The point information includes a point table including a three-dimensional coordinate value of a point and a normal vector ($u_\alpha$, $u_\beta$, $u_\gamma$) of the point for each point ID. The curved line element information has a curved line element table including a point ID of an edge start point, a point ID of an edge end point, a tangent vector at an edge start point, and a tangent vector at an edge end point for each curved line element ID. The triangle information has a triangle table including point IDs, curved line element IDs, orientation (positive direction or negative direction) of the curved line element, and normal vectors of the triangle for each triangle ID. Here, the normal vector and the tangent vector are normalized vectors.

In other words, the differential polyhedron model is a set model of triangles including coordinate values of the triangle vertices ($\alpha$, $\beta$, $\gamma$), normal vectors ($u_\alpha$, $u_\beta$, $u_\gamma$) of the triangle vertices ($\alpha$, $\beta$, $\gamma$), the start/end points formed of the triangle vertices ($\alpha$, $\beta$, $\gamma$), and the tangent vectors ($v1_{\alpha\,\beta}$, $v2_{\alpha\,\beta}$, $v1_{\beta\,\gamma}$, $v2_{\beta\,\gamma}$, $v1_{\gamma\,\alpha}$, $v2_{\gamma\,\alpha}$) at the start/end points.

The tangent vector at the start point and the tangent vector at the end point are normalized vectors, and can be expressed, e.g., by a cubic polynomial curve as shown by Formula 1.

Formula 1

$$\vec{C}(t) = \vec{A}t^3 + \vec{B}t^2 + \vec{C}t + \vec{D} \quad ; 0 \le t \le \text{curved line element length} \qquad (1)$$

Here, $\vec{A}, \vec{B}, \vec{C}$ and $\vec{D}$ are coefficients.

Here, the curved line element includes start/end points consisting of triangle vertices, and tangent vectors at the start/end points, and the length of the curved line element can be expressed by the following Formula 2.

[Formula 2]

$$\int_0^{\text{curved line element length}} \left| \frac{d\vec{C}(t)}{dt} \right| dt \qquad (2)$$

Since the length of the curve appears as the upper limit value of the integration in Formula (2), the coefficients A→, B→, C→, and D→ are determined by repeating the calculation so that the length of the curve = Formula 2.

As shown in FIG. 5B, when a side of the differential polyhedron is a curved line element, a curved surface can be handled as described later by interpolating the two points between the start/end points with a curved line element including the start/end points and tangent vectors at the start/end points. Further, the differential polyhedron is a polygon model of a triangular mesh model and can be converted into obj format which is a data format for CG (Computer Graphics). Therefore, using a differential polyhedron model which is a set of differential polyhedrons can facilitate data cooperation between 3D systems. Further, this achieves high affinity with CG software and can easily express smoothness of a curved surface.

CSG REPRESENTATION DATA STRUCTURE

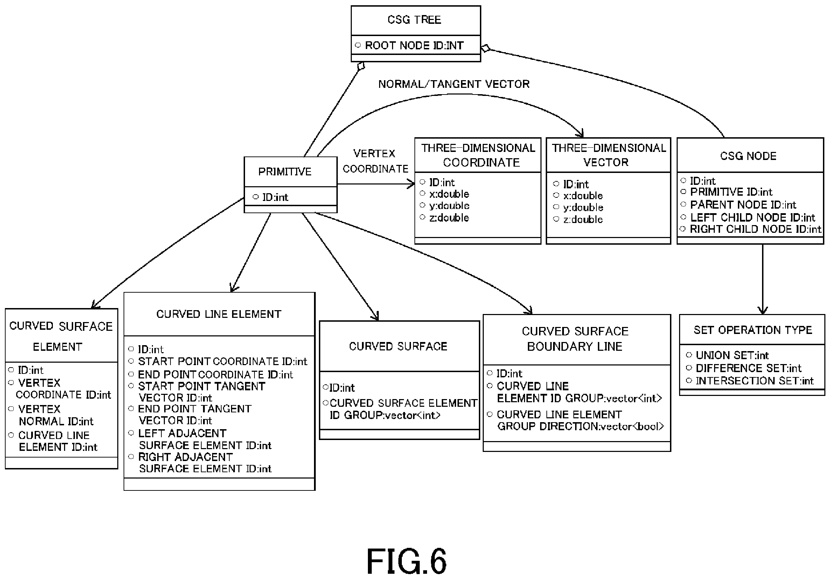

FIG. 6 is a view for explaining the data structure of the primitive and the data structure of the primitive in the CSG representation. The CSG tree node is a root node, and the CSG node and the primitive node are child nodes of the CSG tree node.

The CSG node has a set operation type node as a child node, and has a table including a primitive ID, a parent node ID, a left child node ID, and a right child node ID for each CSG node ID. The primitive node has a three-dimensional coordinate node, a three-dimensional vector node, a curved surface element node, a curved line element node, a curved surface node, and a curved surface boundary line node as child nodes.

The three-dimensional coordinate node has a table including coordinate values (x, y, z) of triangle vertices for each three-dimensional coordinate ID. The three-dimensional coordinate vector has a table including components (x, y, z) of normal vectors and tangent vectors for each three-dimensional vector ID. The curved surface element node has a table including a vertex coordinate ID, a vertex normal ID, and a curved line element ID for each curved surface element ID. The curved surface element is the same as a differential polyhedron. The curved line element node has a table including a start point coordinate ID, an end point coordinate ID, a start point tangent vector ID, an end point tangent vector ID, a left adjacent surface element ID, and a right adjacent surface element ID for each curved line element ID. The curved surface node has a table including a curved surface element ID group for each curved surface ID. The curved surface boundary line node has a table including a curved line element ID group and a curved line element group direction for each curved surface boundary line ID.

Here, the curved surface is a differential polyhedron group surrounded by a curved surface boundary line, and the curved surface boundary line is composed of a series of continuous curved line elements. In other words, the curved surface has differential polyhedron information, and the curved surface boundary line has curved line information. With such a data structure, primitives including curved surfaces can be represented by differential polyhedron models, and set operations on primitives can be performed.

GENERATION OF DIFFERENTIAL POLYHEDRON MODEL

The differential polyhedron model can be converted from a file such as STEP (Standard for the Exchange of Product model data), IGES (Initial Graphics Exchange Specification), or STL (Standard Triangulated Language), for example. STL is also referred to as "StereoLithography".

First, a 3D CAD model is converted into a set model of triangles including coordinate values of triangle vertices and normal vectors of triangle vertices, thereby generating a point table including coordinate values of triangle vertices and normal vectors of triangle vertices and a triangle table including point IDs.

This set model is a model in which normal vectors of vertices calculated from CAD data are added to vertices of a polygon to approximate a curved surface by a triangle polygon with a specified approximation error and output the polygon. The triangular polygon model with normal vectors is output from, e.g., a curved surface represented by a cubic polynomial with a specified accuracy by a program. The triangular polygon model with the normal vectors is preferably output with the precision of a double-precision floating point number.

Next, triangle edges are extracted by using a triangle set model, a curved line element table including a point ID of an edge start point, a point ID of an edge end point, a tangent vector at an edge start point, and a tangent vector at an edge end point is created for each curved line element ID, and the curved line element ID and the direction (positive direction or negative direction) of the curved line element are added to the triangle table.

Thus, it is possible to generate a differential polyhedron model, which is a triangle set model, including coordinate values of triangle vertices $(\alpha, \beta, \gamma)$, normal vectors $(u_\alpha, u_\beta, u_\gamma)$ of the triangle vertices $(\alpha, \beta, \gamma)$, start/end points consisting of the triangle vertices $(\alpha, \beta, \gamma)$, and tangent vectors $(v1_{\alpha\beta}, v2_{\alpha\beta}, v1_{\beta\gamma}, v2_{\beta\gamma}, v1_{\gamma\alpha}, v2_{\gamma\alpha})$ at the start/end points.

CURVED SURFACE AND CURVED SURFACE BOUNDARY LINE

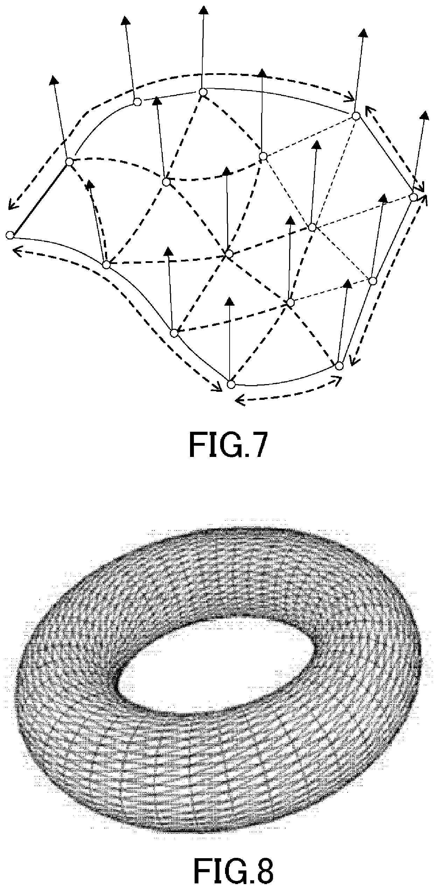

FIG. 7 is a view illustrating an example of the curved surface and a curved surface boundary line, and FIG. 8 is a view illustrating an example of the curved surface having no curved surface boundary line. As shown in FIGS. 7 and 8, the curved surface is formed by connecting differential polyhedrons at vertices thereof, the edges of the curved surface being curved line elements. Since the vertices have respective normal vectors, a normal vector can be given to the center point by subdivision. When this processing is repeated, normal vectors are generated everywhere on the differential polyhedron, and the direction of the differential polyhedron is determined by the direction of the normal vectors. Therefore, even in a curved surface, the direction of the curved surface naturally exists.

The boundary line is a group of smoothly connected curved line elements, as shown by the dashed line range of the double arrows in FIG. 7, and the curved surface is surrounded by a continuous boundary line. The boundary line has an ordered list of curved surface elements constituting one curved surface and an ordered list of curved surface elements constituting the other curved surface, and can express a connection relation of curved surfaces. As shown in FIG. 8, there also exists a curved surface having no boundary line. It should be noted that the definition of the curved surface and the boundary line is a local definition other than the general definition of the curved surface and the boundary line.

CLOSED SURFACE

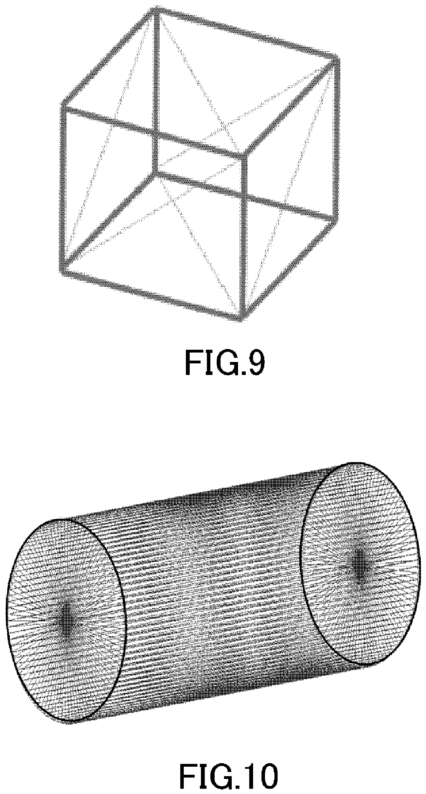

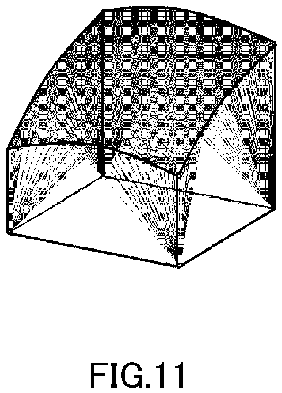

FIG. 9 is a view illustrating a cube as an example of a closed surface, FIG. 10 is a view illustrating a cylinder as an example of a closed surface, and FIG. 11 is a view illustrating a free-form surface as an example of a closed surface. The closed surface is a curved surface constituted by connecting a plurality of curved surfaces with boundary lines. Here, the closed surface shall not be self-intersecting. It is possible to give a direction to the closed surface by normal vectors, and the direction of the closed surface can be inverted by inverting the normal vector of the closed surface.

3. PRIMITIVE SET OPERATIONS

A closed surface separates three-dimensional space into two regions. A set of points on the back side of a closed surface is called a primitive. The primitive has a local coordinate system.

Since a primitive is a set of points, a set operation can be performed on primitives. In the following, set operations are defined clearly since the set operations in this disclosure is partially different from the general set operations.

COMPLEMENT SET

A complement set of a primitive is treated as the closure of a set of non-primitive points in three-dimensional space. Therefore, the complement set of a primitive includes points on the closed surface. The complement set of a primitive means the closure of the complement set of a general set, denoted by the symbol A~, and also refer to as complement set (A). The "complement set of a primitive" may be simply referred to as "complement set".

UNION SET

The union set of primitives is the union set in the general sense. When the union set operation of the primitives A and B is performed to determine the union set, the complement set operation and coordinate conversion of the primitives can be given as attributes.

When the coordinate-converted primitive is represented by $T_A A$, $T_A A \cup T_B B$ indicates that a union set operation is performed after the position is converted by each coordinate conversion. The operation symbol U is union symbol. In addition to union set operation between primitives, union set operations between unions or union set operations between unions and primitives are also possible.

FIG. 12 is a view illustrating an example of the tree structure having a union set and an intersection set of primitives. In FIG. 12, attributes include coordinate conversion and complement set operations. The portion represented by symbols of union set and intersection set in the tree structure are called nodes.

INTERSECTION SET

The intersection of primitives is also the intersection set in the general sense. Similarly to the union set, when the intersection set operation of the primitives A and B is performed to determine the intersection set, the complement set operation and coordinate conversion of the primitives can be given as attributes. Similarly to the union set, when the coordinate-converted primitive is represented by $T_A A$, $T_A A \cap T_B B$ indicates that an intersection set is determined after the position is converted by each coordinate conversion. The operation symbol $\cap$ is intersection symbol. In addition to intersection set operation between primitives, intersection set operation between union sets, intersection set operation between intersection sets, intersection set operation between union sets and intersection sets, and intersection set operation between union/intersection set and a primitive are also possible.

FIG. 13 is a view schematically illustrating an example of a set operation result of a primitive. FIG. 13A is a view schematically illustrating an example of a rectangular primitive A and a cylinder primitive B. FIG. 13B is a view schematically illustrating an example of the union A U B of the rectangular primitive A and the cylinder primitive B. FIG. 13C is a view schematically illustrating an example of the intersection $A \cap B\sim$ of the rectangular primitive A and the cylinder primitive B. $A \cap B\sim$ is the difference determined by subtracting the set of primitive B from the set of primitive A, and the difference between the primitives can be determined by this operation. B~ represents the closure of the complement set of B, and B~ is also refer to as complement set (B). FIG. 13D is a view schematically illustrating an example of the intersection A ∩ B of the rectangular primitive A and the cylinder primitive B.

COMPRESSION OF HIERARCHY

FIG. 14 is a view illustrating an example of the tree structure in which the arithmetic symbol is omitted from the tree structure shown in FIG. 12. In the tree structure of the set operation of primitives, when a lower operation symbol is the same as the upper operation symbol in the hierarchy, the operation symbol can be omitted. This process is referred to as hierarchical compression. For example, the tree structure shown in FIG. 12 can be changed to the tree structure shown in FIG. 14. In the tree structure shown in FIG. 14, the attribute A' is an attribute determined by combining the attribute A and the attribute AB, and similarly, the attribute B' is an attribute determined by combining the attribute B and the attribute AB. The compression of the hierarchy is important when determining the intersection set of the light ray and the solid model by CSG representation in the processing of real-time ray tracing described later.

SET OPERATION

FIG. 15 is a view illustrating an example of the tree structure of a feature, and FIG. 16 is a view illustrating an example of the tree structure of a part. As shown in FIG. 15, a set generated by operation of a union set and an intersection set corresponding to a node is called a feature. Further, as shown in FIG. 16, a set generated at the highest node is called a part. The solid model by CSG representation can be represented in the computer by the definition of primitives and the tree structure.

A feature 1 is a result of separately executing a conversion for scaling and moving rectangular primitives and performing a union set operation of these primitives. The part is created by drilling a hole in the set of the feature 1 by using a cylinder, and can be created by scaling and placing the cylinder primitive and then determining the intersection set of the complement set operation and the feature 1. Such an operation can be performed in the computer only by coordinate conversion and symbol operation.

4. THREE-DIMENSIONAL MODEL REPRESENTATION

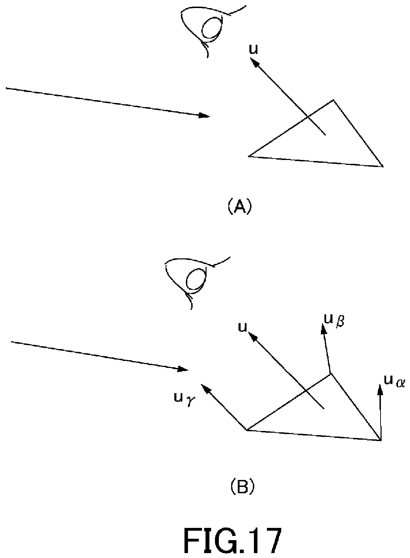

FIG. 17 is a view for explaining shading, in which FIG. 17A is a view for explaining flat shading, and FIG. 17B is a view for explaining Phong shading. Flat shading represents a three-dimensional model by using light reflected in the direction of the normal vector of a triangle of a differential polyhedron model. Phong shading interpolates normal vectors in a triangle with normal vectors of vertices of the triangle of the differential polyhedron model, and then represents the three-dimensional model by using light reflected on the normal vectors.

Thus, by using the differential polyhedron model which is a triangle set model, it is possible to quickly shade and represent the three-dimensional model by quickly calculating the light reflected from the triangles.

The three-dimensional model by CSG representation can use real-time ray tracing. Ray tracing is a method of simulating physical phenomena when a person looks at an object; in particular, ray tracing is a method of tracing reflection, scattering, and attenuation of each light ray with regard to an object or the environment where the object is located to determine the light ray that finally visually recognized by the person. Recently, NVIDIA released GeForce RTX (TM) to provide real-time ray tracing. By customizing this hardware, it is possible to directly render the solid model by CSG representation in real time.

For example, Nvidia OptiX (TM) can be used for real-time ray tracing process. Nvidia OptiX (TM) is a ray tracing API (Application Programming Interface) based on CUDA (Compute Unified Device Architecture). Nvidia OptiX (TM) features the ability to program various ray tracing processes, such as hit determination, hit behavior, and no-hit behavior. By programing the process, a user can efficiently perform ray tracing even for a model to which an existing shader cannot be applied.

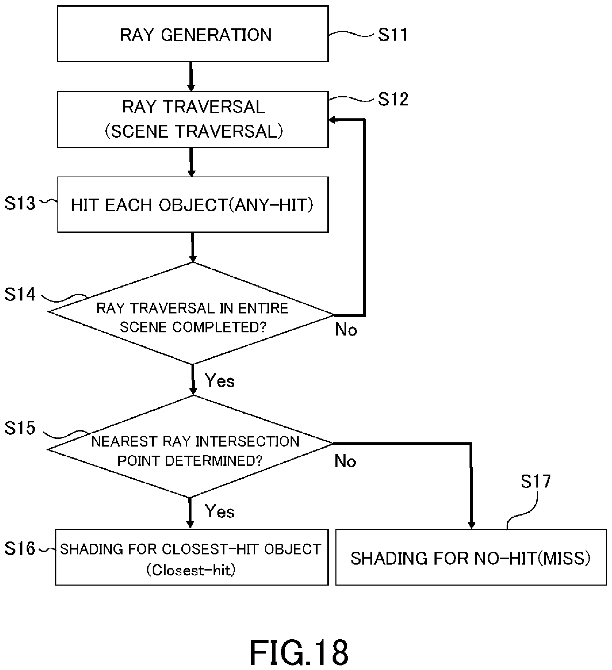

FIG. 18 is a flowchart for explaining the real-time ray tracing process. First, in step S11, a ray (light ray) is generated, and in step S12, the ray traverses each object. Here, the object is the part on the highest level of the feature.

In step S13, a ray is made to hit with each object to determine an intersection point. The closest intersection point of a ray and a part can be determined as follows.

First, intersection point information including a start point bit string, an end point bit string, a temporary bit string, and a final bit string is prepared for each lowest feature. The length of each bit string is the number of intersections between the light ray and all closed surfaces. Intersections between the light ray and the closed surfaces are arranged in the order of the traversal direction of the light ray, and the intersection numbers are assigned from 1 in the order of the traversal direction.

When a light ray enters a closed surface at a point in the closed surface of a primitive directly belonging to a feature, a bit is set at the position of the intersection number in the start point bit string. When a light ray exits the closed surface at a point, a bit is set at the position of the intersection number in the end point bit string.

Next, a temporary bit string is processed by set operation symbols by using the start point bit string and the end point bit string.

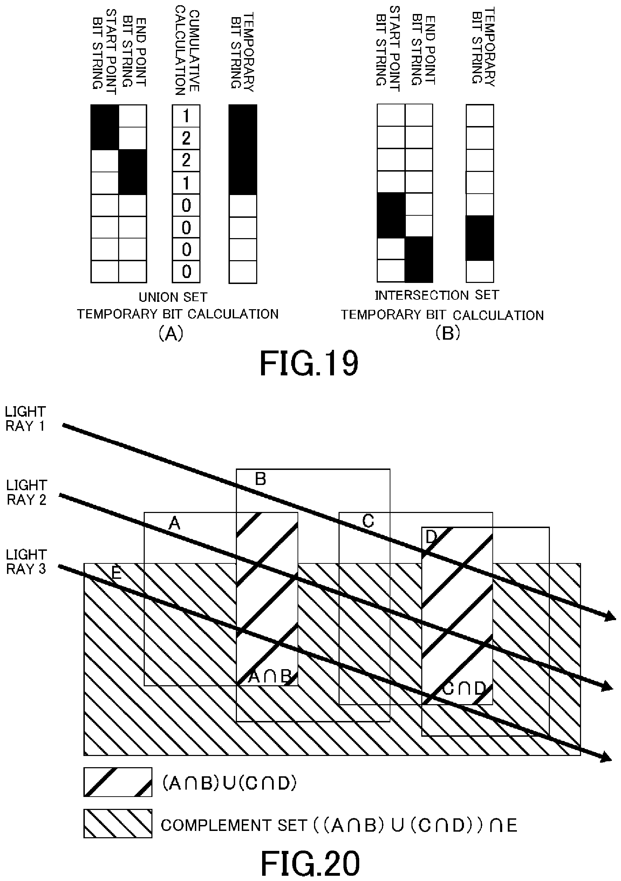

FIG. 19 is a view for explaining a calculation method of a temporary bit string, in which FIG. 19A shows a temporary bit calculation of a union set, and FIG. 19B shows a temporary bit calculation of an intersection set. The union set operation uses an array of the cumulative calculation shown in FIG. 19A, the start point bit string and the end point bit string are checked from the beginning of the column, and 1 is added if a bit is set at the position of the start point bit string. If a bit is set at the position of the end point bit string, 1 is subtracted from the next position. The processing of the temporary bit string ends by setting a bit in non-zero positions in the string. Further, as shown in FIG. 19B, the intersection set operation sets bits in the temporary bit string from the bit-set position having the largest intersection number in the start point bit string to the bit-set position having the smallest intersection number in the end point bit string.

The processing of the final bit string is performed in the order from the lowest feature. For the lowest feature, the temporary bit string is just copied to the final bit string. For the one higher feature, a set operation of its own temporary bit string and the final bit string of the subordinate feature is performed, and the result is used as the final bit string.

In this way, the final bit strings of the feature at the upper levels are sequentially determined, and the final bit string of the part at the highest level of the feature is determined. The position of the smallest intersection number in the final bit string of the part is the intersection point between the light ray and the part, and the reflection position and the reflection direction of the light ray can be determined by the intersection point and the normal vector.

In step S14, it is determined whether the rays in the entire scene have completed the traversal. When it is determined that the all rays in the entire scene have completed the traversal, the process proceeds to step S15, and when it is determined that the all rays in the entire scene have not completed the traversal, the process returns to step S12 so that the ray traverses each object.

In step S15, it is determined whether the nearest intersection point of the ray has been determined. If it is determined that the intersection point has been determined, the process proceeds to step S16, and if it is determined that the intersection point has not been determined, the process proceeds to step S17.

In a step S16, the three-dimensional model is rendered by using the shading for the closest-hit object, and in a step S17, the three-dimensional model is rendered by using the shading for no-hit (miss).

By performing such real-time ray tracing processing in hardware, the reflection position and reflection direction of the light rays in the three-dimensional model can be calculated and rendered in real time.

EXAMPLES

Next, a method for determining the closest intersection point between the light ray and the solid model in CSG representation in the aforementioned step S13 will be described with reference to specific examples.

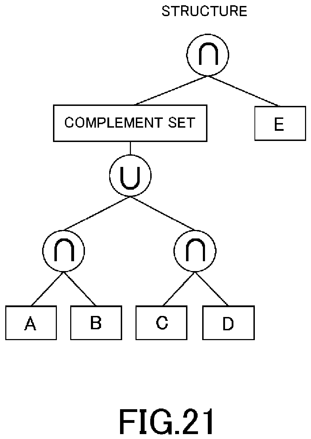

FIG. 20 is a view schematically illustrating a situation where light rays 1 to 3 pass through a solid model in CSG representation, and FIG. 21 is a view illustrating an example of a tree structure of the solid model in CSG representation shown in FIG. 20. In a specific example, as shown in FIG. 20, the range in which the light rays 1 to 3 pass through the three-dimensional model is determined by a set operation using set operation symbols from the lowest layer of the tree structure as shown in FIG. 21, thereby determining the position which the light ray hits first. More specifically, the positions through which the rays 1 to 3 pass are determined in the range of complement set $((A \cap B) \cup (C \cap D)) \cap E$.

Here, the number of features and necessary intersection point information for each feature can be reduced by compressing the hierarchy described above. Further, since there is no change between the intersections of the light rays and the closed surfaces of the primitives constituting the solid model, the information may be considered to be compressed.

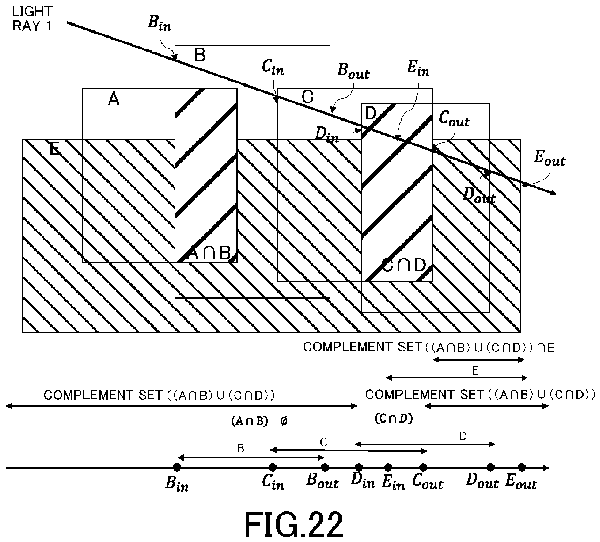

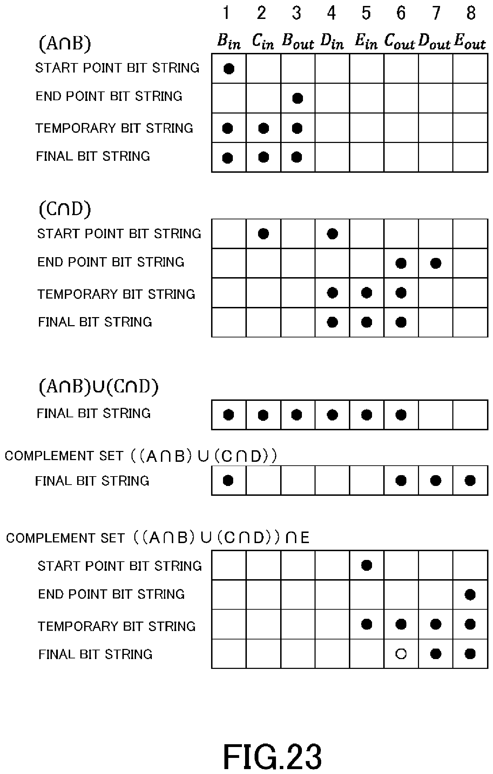

FIG. 22 is a view schematically illustrating a situation where the light ray 1 passes through a solid model in CSG representation, and FIG. 23 is a view for explaining intersection point information where the light ray 1 passes through a feature. As shown in FIG. 22, the ray 1 passes through the closed surfaces of the primitives A to E in the order of $B_{in}$, $C_{in}$, $B_{out}$, $D_{in}$, $E_{in}$, $C_{out}$, $D_{out}$, and $E_{out}$.

As shown in FIG. 23, by using the intersection point information, the final bit string of $(A \cap B)$ and $(C \cap D)$ is determined from the final bit string of $(A \cap B) \cup (C \cap D)$ to determine the final bit string of the complement set $((A \cap B) \cup (C \cap D))$. Here, the final bit string of the complement set $((A \cap B) \cup (C \cap D))$ includes a point on a closed surface; therefore, the final bit string is obtained by inverting the bit-set bit string from the bit-set position having the smallest intersection point number +1 to the bit-set position having the largest intersection point number -1 in the final bit string of $(A \cap B) \cup (C \cap D)$. That is, the final bit string of the complement set $((A \cap B) \cup (C \cap D))$ is obtained by inverting the bit string set at the intersection point numbers 2 to 5. Then, a set operation is performed on the temporary bit string of the complement set $((A \cap B) \cup (C \cap D)) \cap E$ and the final bit string of the complement set $((A \cap B) \cup (C \cap D))$ to determine the final bit string of the complement set $((A \cap B) \cup (C \cap D)) \cap E$. The final bit string shows that the first position of ray 1 passing through the solid model in CSG representation is the position of $C_{out}$ at intersection point number 6.

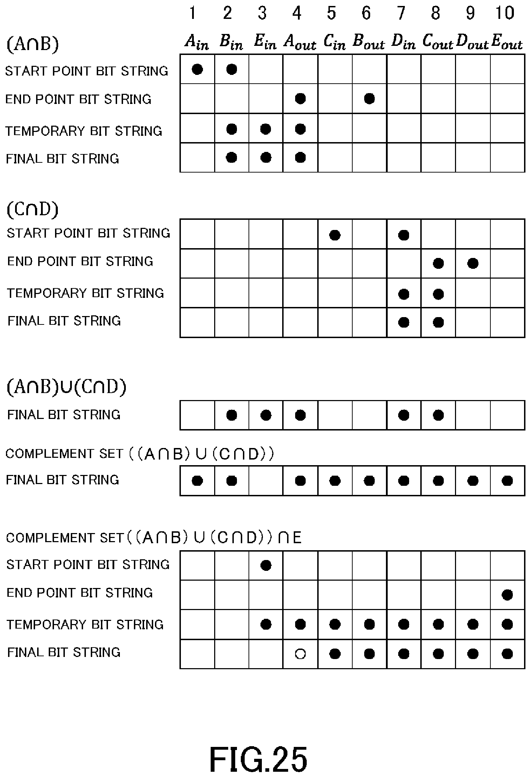

FIG. 24 is a view schematically illustrating a situation where a light ray 2 passes through a solid model in CSG representation, and FIG. 25 is a view for explaining intersection point information where the light ray 2 passes through a feature. As shown in FIG. 24, the ray 2 passes through the closed surfaces of the primitives A to E in the order of $A_{in}$, $B_{in}$, $E_{in}$, $A_{out}$, $C_{in}$, $B_{out}$, $D_{in}$, $C_{out}$, $D_{out}$, and $E_{out}$.

As shown in FIG. 25, as with the above example, by using the intersection point information, the final bit string of $(A \cap B)$ and $(C \cap D)$ is determined from the final bit string of $(A \cap B) \cup (C \cap D)$ to determine the final bit string of the complement set $((A \cap B) \cup (C \cap D))$. The final bit string of the complement set $((A \cap B) \cup (C \cap D))$ is obtained by inverting the bit set at intersection point number 3. Then, a set operation is performed on the temporary bit string of the complement set $((A \cap B) \cup (C \cap D)) \cap E$ and the final bit string of the complement set $((A \cap B) \cup (C \cap D))$ to determine the final bit string of the complement set $((A \cap B) \cup (C \cap D)) \cap E$. The final bit string shows that the first position of ray 2 passing through the solid model in CSG representation is the position of $A_{out}$ at intersection point number 4.

FIG. 26 is a view schematically illustrating a situation where a light ray 3 passes through a solid model in CSG representation, and FIG. 27 is a view for explaining intersection point information where the ray 3 passes through a feature. As shown in FIG. 26, the ray 3 passes through the closed surfaces of the primitives A to E in the order of $E_{in}$, $A_{in}$, $B_{in}$, $A_{out}$, $C_{in}$, $B_{out}$, $D_{in}$, $C_{out}$, $D_{out}$, and $E_{out}$.

As shown in FIG. 27, as with the above example, by using the intersection point information, the final bit string of $(A \cap B)$ and $(C \cap D)$ is determined from the final bit string of $(A \cap B) \cup (C \cap D)$ to determine the final bit string of the complement set $((A \cap B) \cup (C \cap D))$. The final bit string of the complement set $((A \cap B) \cup (C \cap D))$ is obtained by inverting the bit string to which bits are not set. Then, a set operation is performed on the temporary bit string of the complement set $((A \cap B) \cup (C \cap D)) \cap E$ and the final bit string of the complement set $((A \cap B) \cup (C \cap D))$ to determine the final bit string of the complement set $((A \cap B) \cup (C \cap D)) \cap E$. The final bit string shows that the first position of ray 3 passing through the solid model in CSG representation is the position of $E_{in}$ at intersection point number 1.

RENDERING EXAMPLES

FIG. 28 is a view illustrating a rendering example of the feature 1 shown in FIG. 15. FIG. 29 is a view illustrating a rendering example of the part shown in FIG. 16. FIG. 30 is a rendering example of the part obtained by performing a union set operation of the feature 1 and the cylinder.

Since a three-dimensional CAD system renders a three-dimensional model in a two-dimensional screen, the viewpoint is frequently changed for model recognition; by using the differential polyhedron model which is a triangle set model, to quickly calculate the light reflected from the triangles in the three-dimensional model, it is possible to quickly process the rendering when a viewpoint is changed. In particular, by using hardware capable of real-time ray tracing, a solid model by CSG representation can be rendered in real time.

REFERENCE SIGNS LIST

1 shape processing unit, 2 storage unit, 3 representation processing unit, 4 data conversion unit, 11 primitive generation unit, 12 set operation processing unit, 13 construction line generation unit, 21 CPU, 22 GPU, 23 ROM, 24 RAM, 25 operation input unit, 26 storage, 27 input/output interface

**Claims**

1.  A three-dimensional CAD system comprising:

    a primitive generation unit that uses a differential polyhedron model which is a set of differential polyhedrons including coordinate values of triangle vertices, normal vectors of the triangle vertices, and curved line elements including start/end points consisting of the triangle vertices and tangent vectors at the start/end points to form a curved surface by connecting sides of the differential polyhedron and form a closed surface by connecting curved surfaces with a curved surface boundary line, thereby generating a primitive which is a set of points belonging to the inside of the closed surface; and
    a storage unit that stores CSG data which represents a solid model in CSG representation by a tree structure of set operations of the primitives; and
    a representation processing unit that determines an intersection point between the solid model and a straight line from the intersection point between the closed surface of the primitive and the straight line by a set operation based on the CSG data, thereby calculating a reflection position and a reflection direction of a light ray in the solid model.

**2.** The three-dimensional CAD system according to claim 1, wherein the primitive generation unit generates the differential polyhedron by adding, on the basis of the coordinate values of the triangle vertices and the normal vectors of the triangle vertices, curved line elements including start/end points consisting of the triangle vertices and tangent vectors at the start/end points.

**3.** The three-dimensional CAD system according to claim 1 or 2, wherein the primitive generation unit generates a spatial geodesic by using coordinate values of triangle vertices shared by adjacent first and second differential polyhedrons and normal vectors of the triangle vertices to construct a connection relation by sharing the spatial geodesic, thereby forming a curved surface.

**4.** The three-dimensional CAD system according to any one of claims 1 to 3, wherein the primitive generation unit constructs a connection relation between the curved surfaces by using a curved line element shared between the curved surfaces, thereby forming a closed surface connecting the curved surfaces.

**5.** The three-dimensional CAD system according to any one of claims 1 to 4, wherein the curved line element composed of tangent vectors at the start/end points is represented by a cubic polynomial curve shown by Formula 1.
[Formula 1]

$$\vec{C}(t) = \vec{A}t^3 + \vec{B}t^2 + \vec{C}t + \vec{D} \quad ; 0 \leq t \leq \text{curved line element length} \qquad (1)$$

Here, $\vec{A}, \vec{B}, \vec{C}$ and $\vec{D}$ are coefficients.

**6.** The three-dimensional CAD system according to any one of claims 1 to 5, wherein the representation processing unit omits a set operation symbol and determines an intersection point between the solid model and the light ray in the tree structure of set operations of the primitives, when a lower set operation symbol is a same as an upper set operation symbol in a hierarchy.

**7.** The three-dimensional CAD system according to any one of claims 1 to 6, wherein the representation processing unit uses real-time ray tracing to determine an intersection point between the solid model and the light ray.

**8.** The three-dimensional CAD system according to any one of claims 1 to 7, further comprising a construction line generation unit that generates an intersection line of two primitives as a construction line, wherein the primitive generation unit generates a new primitive based on the construction line.

**9.** A three-dimensional CAD method including:

a primitive generation step of using a differential polyhedron model which is a set of differential polyhedrons including coordinate values of triangle vertices, normal vectors of the triangle vertices, and curved line elements including start/end points consisting of the triangle vertices and tangent vectors at the start/end points to form a curved surface by connecting sides of the differential polyhedron and form a closed surface by connecting curved surfaces with a curved surface boundary line, thereby generating a primitive which is a set of points belonging to the inside of the closed surface;
a storage step of storing CSG data which represents a solid model in CSG representation by a tree structure of set operations of the primitives; and
a representation processing step of determining an intersection point between the solid model and a straight line from the intersection point between the closed surface of the primitive and the straight line by a set operation based on the CSG data, thereby calculating a reflection position and a reflection direction of a light ray in the solid model.

**10.** A three-dimensional CAD program that causes a computer to execute:

a primitive generation step of using a differential polyhedron model which is a set of differential polyhedrons including coordinate values of triangle vertices, normal vectors of the triangle vertices, and curved line elements including start/end points consisting of the triangle vertices and tangent vectors at the start/end points to form a curved surface by connecting sides of the differential polyhedron and form a closed surface by connecting curved surfaces with a curved surface boundary line, thereby generating a primitive which is a set of points belonging to the inside of the closed surface;

a storage step of storing CSG data which represents a solid model in CSG representation by a tree structure of set operations of the primitives; and

a representation processing step of determining an intersection point between the solid model and a straight line from the intersection point between the closed surface of the primitive and the straight line by a set operation based on the CSG data, thereby calculating a reflection position and a reflection direction of a light ray in the solid model.

FIG.1

FIG.2

(A)

SPATIAL GEODESIC    SPATIAL GEODESIC

SPATIAL GEODESIC

(B)

FIRST DIFFERENTIAL POLYHEDRON

(C)

SECOND DIFFERENTIAL POLYHEDRON

(D)

FIG.3

CURVED
LINE
ELEMENT

(A)

SPATIAL GEODESIC    SPATIAL GEODESIC

CURVED
LINE
ELEMENT

(B)

FIRST DIFFERENTIAL POLYHEDRON

CENTER POINT    CENTER VECTOR

(C)

FIG.4

$u_\beta$

$v2_{\alpha\beta}$

VERTEX $\beta$

$u_\gamma$

SIDE $\beta\gamma$

SIDE $\alpha\beta$

$u_\alpha$

$v1_{\alpha\gamma}$

VERTEX $\gamma$

SIDE $\gamma\alpha$

VERTEX $\alpha$

(A)

$v1_{\alpha\beta}$

VERTEX $\alpha$

VERTEX $\beta$

SIDE $\alpha\beta$

$v2_{\alpha\beta}$

(B)

# FIG.5

FIG.6

FIG.7

FIG.8

FIG.9

FIG.10

FIG.11

U

| ATTRIBUTE AB | ATTRIBUTE CD | ATTRIBUTE E |

UNION SET AB        INTERSECTION
                    SET CD

U          ∩

Primitive
E

| ATTRIBUTE A | ATTRIBUTE B | ATTRIBUTE C | ATTRIBUTE D |

| Primitive A | Primitive B | Primitive C | Primitive D |

FIG.12

(A)          (B)          (C)          (D)

FIG.13

FIG.14

FIG.15

FIG.16

(A)

(B)

# FIG.17

RAY GENERATION — S11

RAY TRAVERSAL
(SCENE TRAVERSAL) — S12

S13 — HIT EACH OBJECT(ANY-HIT)

S14 — RAY TRAVERSAL IN ENTIRE
SCENE COMPLETED?

No

Yes

S15 — NEAREST RAY INTERSECTION
POINT DETERMINED?

No

S17

Yes

S16 — SHADING FOR CLOSEST-HIT OBJECT
(Closest-hit)

SHADING FOR NO-HIT(MISS)

FIG.18

START POINT BIT STRING
END POINT BIT STRING
CUMULATIVE CALCULATION
TEMPORARY BIT STRING

| | |
|---|---|
| ■ | |
| | ■ |
| | |
| | |
| | |
| | |
| | |

| |
|---|
| 1 |
| 2 |
| 2 |
| 1 |
| 0 |
| 0 |
| 0 |
| 0 |

UNION SET
TEMPORARY BIT CALCULATION
(A)

START POINT BIT STRING
END POINT BIT STRING
TEMPORARY BIT STRING

| | |
|---|---|
| | |
| | |
| | |
| ■ | |
| | ■ |
| | |

INTERSECTION SET
TEMPORARY BIT CALCULATION
(B)

## FIG.19

LIGHT RAY 1

LIGHT RAY 2

LIGHT RAY 3

B

A          C

D

E

A ∩ B          C ∩ D

(A ∩ B) ∪ (C ∩ D)

COMPLEMENT SET ((A ∩ B) ∪ (C ∩ D)) ∩ E

## FIG.20

STRUCTURE

FIG.21

LIGHT
RAY 1

$B_{in}$

B

$C_{in}$

$B_{out}$

$E_{in}$

A

C

$C_{out}$

D

$D_{in}$

$E_{out}$

E

$D_{out}$

A∩B

C∩D

COMPLEMENT SET((A∩B)∪(C∩D))∩E

E

COMPLEMENT SET ((A∩B)∪(C∩D))

COMPLEMENT SET ((A∩B)∪(C∩D))

(A∩B)=∅

(C∩D)

C

D

B

$B_{in}$  $C_{in}$  $B_{out}$  $D_{in}$  $E_{in}$  $C_{out}$  $D_{out}$  $E_{out}$

# FIG.22

(A∩B)

| | 1 | 2 | 3 | 4 | 5 | 6 | 7 | 8 |
| | $B_{in}$ | $C_{in}$ | $B_{out}$ | $D_{in}$ | $E_{in}$ | $C_{out}$ | $D_{out}$ | $E_{out}$ |
|---|---|---|---|---|---|---|---|---|
| START POINT BIT STRING | ● | | | | | | | |
| END POINT BIT STRING | | | ● | | | | | |
| TEMPORARY BIT STRING | ● | ● | ● | | | | | |
| FINAL BIT STRING | ● | ● | ● | | | | | |

(C∩D)

| | $B_{in}$ | $C_{in}$ | $B_{out}$ | $D_{in}$ | $E_{in}$ | $C_{out}$ | $D_{out}$ | $E_{out}$ |
|---|---|---|---|---|---|---|---|---|
| START POINT BIT STRING | | ● | | ● | | | | |
| END POINT BIT STRING | | | | | | ● | ● | |
| TEMPORARY BIT STRING | | | | ● | ● | ● | | |
| FINAL BIT STRING | | | | ● | ● | ● | | |

(A∩B)∪(C∩D)

| | | | | | | | | |
|---|---|---|---|---|---|---|---|---|
| FINAL BIT STRING | ● | ● | ● | ● | ● | ● | | |

COMPLEMENT SET ((A∩B)∪(C∩D))

| | | | | | | | | |
|---|---|---|---|---|---|---|---|---|
| FINAL BIT STRING | ● | | | | | ● | ● | ● |

COMPLEMENT SET ((A∩B)∪(C∩D))∩E

| | | | | | | | | |
|---|---|---|---|---|---|---|---|---|
| START POINT BIT STRING | | | | | ● | | | |
| END POINT BIT STRING | | | | | | | | ● |
| TEMPORARY BIT STRING | | | | | ● | ● | ● | ● |
| FINAL BIT STRING | | | | | | ○ | ● | ● |

# FIG.23

FIG.24

# (A∩B)

| | $A_{in}$ (1) | $B_{in}$ (2) | $E_{in}$ (3) | $A_{out}$ (4) | $C_{in}$ (5) | $B_{out}$ (6) | $D_{in}$ (7) | $C_{out}$ (8) | $D_{out}$ (9) | $E_{out}$ (10) |
|---|---|---|---|---|---|---|---|---|---|---|
| START POINT BIT STRING | ● | ● | | | | | | | | |
| END POINT BIT STRING | | | | ● | | ● | | | | |
| TEMPORARY BIT STRING | | ● | ● | ● | | | | | | |
| FINAL BIT STRING | | ● | ● | ● | | | | | | |

# (C∩D)

| | $A_{in}$ (1) | $B_{in}$ (2) | $E_{in}$ (3) | $A_{out}$ (4) | $C_{in}$ (5) | $B_{out}$ (6) | $D_{in}$ (7) | $C_{out}$ (8) | $D_{out}$ (9) | $E_{out}$ (10) |
|---|---|---|---|---|---|---|---|---|---|---|
| START POINT BIT STRING | | | | | ● | | ● | | | |
| END POINT BIT STRING | | | | | | | | ● | ● | |
| TEMPORARY BIT STRING | | | | | | | ● | ● | | |
| FINAL BIT STRING | | | | | | | ● | ● | | |

# (A∩B)∪(C∩D)

| | $A_{in}$ (1) | $B_{in}$ (2) | $E_{in}$ (3) | $A_{out}$ (4) | $C_{in}$ (5) | $B_{out}$ (6) | $D_{in}$ (7) | $C_{out}$ (8) | $D_{out}$ (9) | $E_{out}$ (10) |
|---|---|---|---|---|---|---|---|---|---|---|
| FINAL BIT STRING | | ● | ● | ● | | | ● | ● | | |

COMPLEMENT SET ((A∩B)∪(C∩D))

| | $A_{in}$ (1) | $B_{in}$ (2) | $E_{in}$ (3) | $A_{out}$ (4) | $C_{in}$ (5) | $B_{out}$ (6) | $D_{in}$ (7) | $C_{out}$ (8) | $D_{out}$ (9) | $E_{out}$ (10) |
|---|---|---|---|---|---|---|---|---|---|---|
| FINAL BIT STRING | ● | ● | | ● | ● | ● | ● | ● | ● | ● |

COMPLEMENT SET((A∩B)∪(C∩D))∩E

| | $A_{in}$ (1) | $B_{in}$ (2) | $E_{in}$ (3) | $A_{out}$ (4) | $C_{in}$ (5) | $B_{out}$ (6) | $D_{in}$ (7) | $C_{out}$ (8) | $D_{out}$ (9) | $E_{out}$ (10) |
|---|---|---|---|---|---|---|---|---|---|---|
| START POINT BIT STRING | | | ● | | | | | | | |
| END POINT BIT STRING | | | | | | | | | | ● |
| TEMPORARY BIT STRING | | | ● | ● | ● | ● | ● | ● | ● | ● |
| FINAL BIT STRING | | | | ○ | ● | ● | ● | ● | ● | ● |

# FIG.25

FIG.26

|  | 1 | 2 | 3 | 4 | 5 | 6 | 7 | 8 | 9 | 10 |
|---|---|---|---|---|---|---|---|---|---|---|
| (A∩B) | $E_{in}$ | $A_{in}$ | $B_{in}$ | $A_{out}$ | $C_{in}$ | $B_{out}$ | $D_{in}$ | $C_{out}$ | $D_{out}$ | $E_{out}$ |
| START POINT BIT STRING |  | ● | ● |  |  |  |  |  |  |  |
| END POINT BIT STRING |  |  |  | ● |  | ● |  |  |  |  |
| TEMPORARY BIT STRING |  |  | ● | ● |  |  |  |  |  |  |
| FINAL BIT STRING |  |  | ● | ● |  |  |  |  |  |  |

(C∩D)

|  | 1 | 2 | 3 | 4 | 5 | 6 | 7 | 8 | 9 | 10 |
|---|---|---|---|---|---|---|---|---|---|---|
| START POINT BIT STRING |  |  |  |  | ● |  | ● |  |  |  |
| END POINT BIT STRING |  |  |  |  |  |  |  | ● | ● |  |
| TEMPORARY BIT STRING |  |  |  |  |  |  | ● | ● |  |  |
| FINAL BIT STRING |  |  |  |  |  |  | ● | ● |  |  |

(A∩B)∪(C∩D)

|  | 1 | 2 | 3 | 4 | 5 | 6 | 7 | 8 | 9 | 10 |
|---|---|---|---|---|---|---|---|---|---|---|
| FINAL BIT STRING |  |  | ● | ● |  |  | ● | ● |  |  |

COMPLEMENT SET ((A∩B) ∪ (C∩D))

|  | 1 | 2 | 3 | 4 | 5 | 6 | 7 | 8 | 9 | 10 |
|---|---|---|---|---|---|---|---|---|---|---|
| FINAL BIT STRING | ● | ● | ● | ● | ● | ● | ● | ● | ● | ● |

COMPLEMENT SET ((A∩B) ∪ (C∩D)) ∩ E

|  | 1 | 2 | 3 | 4 | 5 | 6 | 7 | 8 | 9 | 10 |
|---|---|---|---|---|---|---|---|---|---|---|
| START POINT BIT STRING | ● |  |  |  |  |  |  |  |  |  |
| END POINT BIT STRING |  |  |  |  |  |  |  |  |  | ● |
| TEMPORARY BIT STRING | ● | ● | ● | ● | ● | ● | ● | ● | ● | ● |
| FINAL BIT STRING | ○ | ● | ● | ● | ● | ● | ● | ● | ● | ● |

# FIG.27

FIG.28

FIG.29

FIG.30

FIG.31

FIG.32

## INTERNATIONAL SEARCH REPORT

International application No.

**PCT/JP2021/039854**

### A. CLASSIFICATION OF SUBJECT MATTER

*G06F 30/10*(2020.01)i
FI: G06F30/10 100

According to International Patent Classification (IPC) or to both national classification and IPC

### B. FIELDS SEARCHED

Minimum documentation searched (classification system followed by classification symbols)

G06F30/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

IEEE Xplore; JSTPlus (JDreamIII)

### C. DOCUMENTS CONSIDERED TO BE RELEVANT

| Category* | Citation of document, with indication, where appropriate, of the relevant passages | Relevant to claim No. |
|---|---|---|
| Y | FOLEY, James D. et al.著,佐藤義雄訳. コンピュータ グラフィックス 理論と実践. First Edition, Ohmsha, Ltd., 23 March 2001, ISBN: 4-274-06405-0, pp. 471-527, 531-559, 709-711, (Computer Graphics: Principles and Practice (tr. SATO Yoshio).)<br>in particular, "11.1.3. Plane Expression", "11.2.1. Hermite Curves", "11.3.1. Cubic Hermite Surfaces", "12.1. 3D Representation", "12.2. Normalized Boolean Set Operations", "12.7. CSG", "15.10.3. Calculation of Boolean Set Operations" | 1-10 |
| Y | AKENINE-MOELLER Tomas et al.著,中本浩ほか訳. リアルタイムレンダリング. Fourth Edition, Born Digital, Inc., ISBN: 978-4-86246-458-3, pp. 619-673, (Real-Time Rendering (tr. NAKAMOTO Hiroshi et al.).)<br>in particular, "17.1.4. Cubic Hermite Interpolation", "17.2. Parametric Curved Surfaces", "17.2.4. PN Triangles", "17.2.5. Phong Tessellation" | 1-10 |
| A | ROMEIRO, Fabiano et al. Hardware-assisted Rendering of CSG Models. 2006 19th Brazilian Symposium on Computer Graphics and Image Processing [online], 08 October 2006 [retrieved on 11 January 2022], pp. 139-146, Retrieved from: IEEE Xplore, <DOI: https://doi.org/10.1109/SIBGRAPI.2006.24><br>entire text, all drawings | 1-10 |

☑ Further documents are listed in the continuation of Box C.   ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **11 January 2022** | **18 January 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2021/039854**

### C.    DOCUMENTS CONSIDERED TO BE RELEVANT

| Category* | Citation of document, with indication, where appropriate, of the relevant passages | Relevant to claim No. |
|---|---|---|
| A | US 2004/0170302 A1 (MUSETH, Ken) 02 September 2004 (2004-09-02)<br>entire text, all drawings | 1-10 |

Form PCT/ISA/210 (second sheet) (January 2015)

**INTERNATIONAL SEARCH REPORT**
Information on patent family members

International application No.

**PCT/JP2021/039854**

| Patent document cited in search report | Publication date (day/month/year) | Patent family member(s) | Publication date (day/month/year) |
|---|---|---|---|
| US 2004/0170302 A1 | 02 September 2004 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MARTTI MANTYLA**. *Introduction to Solid Modeling*, 1988